# DEMANDE DE BREVET EUROPEEN

(11) **EP 1 168 596 A2**
(43) Date de publication de la demande: **02.01.2002**
(21) Numéro de dépôt: 01440080.8
(22) Date de dépôt: 21.03.2001
(51) Int. Cl.: H03B 21/04, H03H 7/46

(54) **Dispositif générateur de signaux RF à fréquences multiples**

(30) Priorité: 25.05.2000 FR 0006699
(71) Demandeur: BRUKER SA, 67160 Wissembourg (FR)
(72) Inventeur: Weiss, Michel, 67240 Gries (FR); Tyburn, Jean-Max, 67160 Wissembourg (FR); Brevard, Christian, 67160 Wissembourg (FR); Martinache, Laurent, 67500 Marienthal (FR)
(74) Mandataire: Nuss, Pierre

(57) **Abrégé**

La présente invention concerne un dispositif générateur de signaux électriques radiofréquence, délivrant au moins deux signaux distincts ayant des fréquences différentes, sous la forme de signaux délivrés par des sources primaires différentes et amplifiés avec un gain déterminé.

Dispositif, caractérisé en ce qu'il comprend, outre lesdites sources primaires (2), d'une part, un circuit combineur (3), combinant entre eux les signaux (s) délivrés par les sources primaires (2), d'autre part, par un amplificateur de puissance monovoie (4) et, enfin, par une unité (5) de sélection et de routage multivoie à structure parallèle, dont chaque voie délivre en sortie un signal amplifié (S) à une fréquence (F) caractéristique d'une des sources primaires (2) et comprend un circuit bouchon (6) réglé pour être passant pour l'une des différentes fréquences caractéristiques (F) des différentes sources primaires (2), un circuit d'adaptation d'impédance (7) et un circuit de réjection (8) pour les fréquences autres que la fréquence passante du circuit bouchon (6) de la voie concernée.

## Description

La présente invention concerne la fourniture de signaux radiofréquence (RF) de moyenne ou forte puissance, à des fréquences différentes, notamment dans le domaine de l'instrumentation scientifique mettant en oeuvre la résonance magnétique nucléaire (RMN), et a pour objet un dispositif de générateur de signaux RF à des fréquences multiples.

Actuellement, dans la plupart des cas de fourniture de signaux RF à des fréquences différentes et avec un certain niveau de puissance, on procède en mettant en oeuvre autant de couples [source / amplificateur] qu'il y a de signaux de fréquences différentes à délivrer, la source et l'amplificateur de chaque couple étant conçus et adaptés à la bande de fréquence correspondante.

Il en résulte une structure complexe, chaque amplificateur nécessitant une alimentation particulière, et très rigide en termes de caractéristiques et de paramétrage.

Différentes solutions ont été proposées pour essayer de surmonter ces inconvénients, en tentant de réduire le nombre d'amplificateurs.

Toutefois, ces solutions ne donnent pas satisfaction, soit parce que les signaux produits ne présentaient pas les puissances, les qualités et/ou la pureté fréquentielle souhaitées, soit que la constitution de la réalisation obtenue était plus complexe encore ou au moins aussi complexe, notamment en termes d'alimentation, que la solution traditionnelle du fait de la mise en oeuvre d'un nombre équivalent de composants ou de circuits actifs.

Le problème posé à la présente invention consiste par conséquent à proposer une structure de dispositif générateur du type précité, délivrant des signaux avec des caractéristiques équivalentes à celles de la solution traditionnelle ci-dessus, et ne comprenant plus qu'un circuit amplificateur large bande et sans autre circuit actif additionnel à l'exception des sources de signaux modulés.

A cet effet, la présente invention a pour objet un dispositif générateur de signaux électriques radiofréquence, délivrant au moins deux signaux distincts ayant des fréquences différentes, sous la forme de signaux délivrés par des sources primaires différentes et amplifiés avec un gain déterminé, caractérisé en ce qu'il comprend, outre lesdites sources primaires, d'une part, un circuit combineur, combinant entre eux, sans intermodulation, les signaux délivrés par les sources primaires, d'autre part, par un amplificateur de puissance large bande monovoie présentant une bande passante adaptée aux différentes fréquences des signaux présents dans le signal combiné issu du circuit combineur et, enfin, par une unité de sélection et de routage multivoie à structure parallèle, dont chaque voie délivre en sortie un signal amplifié à une fréquence caractéristique d'une des sources primaires et comprend un circuit bouchon réglé pour être passant pour l'une des différentes fréquences caractéristiques des différentes sources primaires, un circuit d'adaptation d'impédance et un circuit de réjection pour les fréquences autres que la fréquence passante du circuit bouchon de la voie concernée.

Le principe à la base de l'invention consiste par conséquent à combiner, sans les mélanger, les signaux élémentaires issus des différentes sources, à les acheminer sur une unique voie vers un circuit d'amplification unique, puis à extraire par sélection du signal combiné amplifié les différents signaux élémentaires et à délivrer, au niveau de sorties distinctes, des signaux élémentaires amplifiés.

L'invention concerne également un dispositif d'analyse à résonance magnétique nucléaire à plusieurs sondes ou têtes de mesure notamment un spectromètre, caractérisé en ce que ses têtes ou sondes de mesure sont alimentées par un dispositif générateur tel que mentionné ci-dessus.

La présente invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 1 est un schéma de principe représentant un dispositif générateur selon l'invention délivrant trois signaux amplifiés avec trois fréquences différentes ;
la figure 2 est un schéma électrique de l'unité de sélection et de routage faisant partie du dispositif représenté à la figure 1, et,
la figure 3 est un schéma de principe partiel, similaire à celui de la figure 1, d'un dispositif d'analyse RMN comprenant un dispositif générateur selon une variante de réalisation de l'invention.

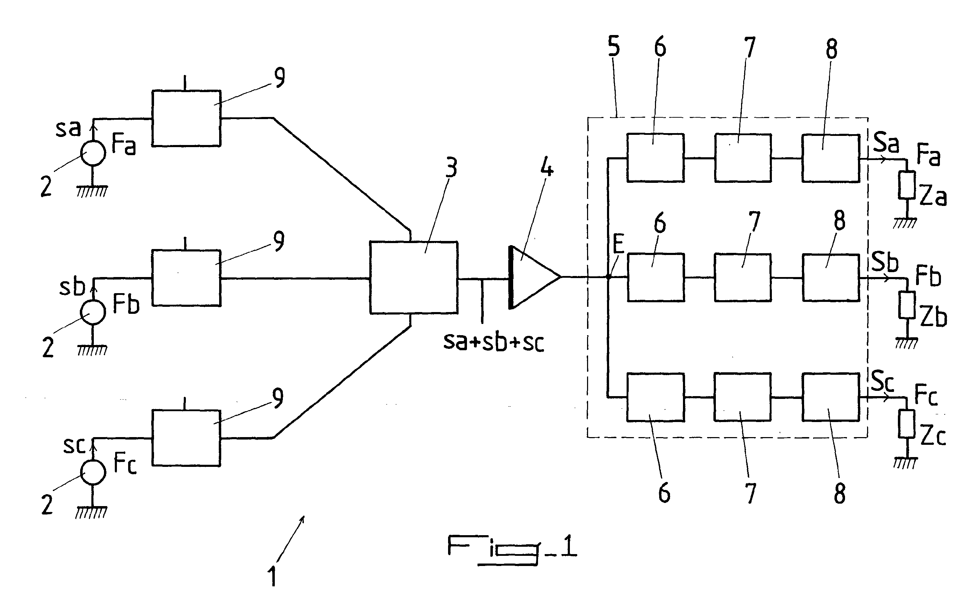

Comme le montre notamment la figure 1 des dessins annexés, le dispositif générateur 1 comprend essentiellement, outre les sources primaires 2 de signaux radiofréquences sa, sb, sc, d'une part, un circuit combineur 3, combinant entre eux, sans intermodulation, les signaux s délivrés par les sources primaires 2, d'autre part, par un amplificateur de puissance large bande monovoie 4 présentant une bande passante adaptée aux différentes fréquences F des signaux présents dans le signal combiné issu du circuit combineur 3 et, enfin, par une unité 5 de sélection et de routage multivoie à structure parallèle, dont chaque voie délivre en sortie un signal amplifié S à une fréquence F caractéristique d'une des sources primaires 2 et comprend un circuit bouchon 6 réglé pour être passant pour l'une des différentes fréquences caractéristiques F des différentes sources primaires 2, un circuit d'adaptation d'impédance 7 et un circuit de réjection 8 pour les fréquences autres que la fréquence passante du circuit bouchon 6 de la voie concernée.

Dans le cadre d'une variante avantageuse de réalisation pratique, entraînant une simplification notable des difficultés liées à des alimentations multiples, tout en évitant les problèmes de discrimination insuffisante du fait d'un rapprochement trop important des différentes fréquences des signaux à amplifier, l'unité 5 de sélection et de routage comporte au moins trois voies parallèles, préférentiellement entre trois et cinq voies, chaque voie délivrant en sortie un signal amplifié S dont la fréquence F correspond à celle d'une source primaire 2 spécifique.

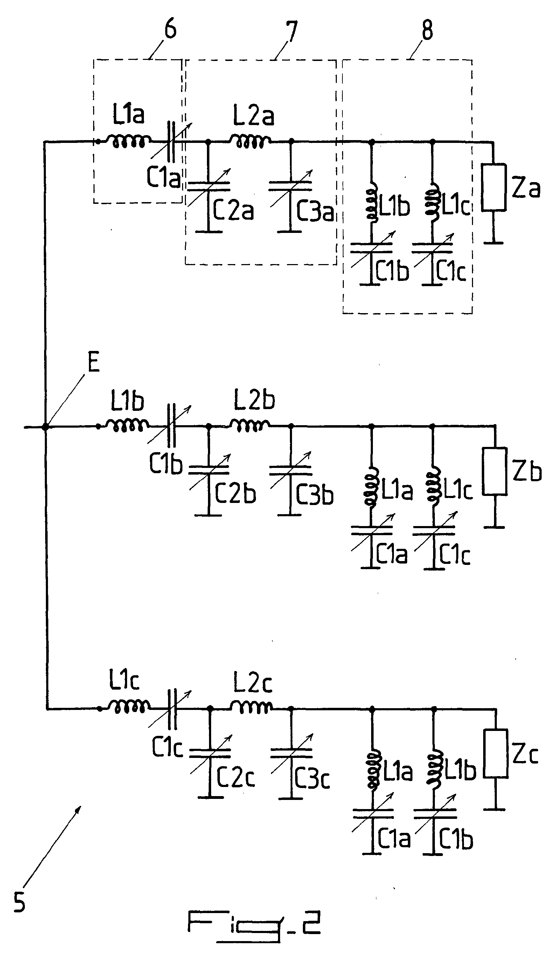

Conformément à un mode de réalisation préféré, notamment en termes de coûts, représenté à la figure 2 des dessins annexés, chaque circuit bouchon 6 consiste en un circuit L-C série, dont la capacité C1 variable est ajustée pour rendre ledit circuit bouchon 6 résonant à la fréquence de sortie F de la voie concernée, chaque circuit d'adaptation consiste en un circuit C-L-C en pi, dont les capacités variables C1 et C2 sont ajustées pour réaliser une adaptation de la voie concernée à la charge Z alimentée par cette dernière et chaque circuit de réjection 8 consiste en plusieurs circuits L-C série montés en parallèle, dont chacun est ajusté pour être résonant à l'une des différentes fréquences de sortie F du dispositif 1, autres que celle de la voie concernée de l'unité 5.

Les circuits de réjection 8 assurent, en complément aux circuits bouchons 6, une augmentation de la discrimination ou de la réjection inter fréquences par l'intermédiaire de filtres coupe-bande à bande étroite parallèles réglés sur les fréquences à réjecter.

On remarquera la simplicité de construction et de réglage que permet d'obtenir cette disposition, le circuit de réjection 8 d'une voie étant formé de circuits L-C série identiques aux circuits bouchons 6 des autres voies de l'unité 5.

En ce qui concerne l'interprétation de la figure 2, correspondant à un exemple de réalisation de l'invention adaptée à la fourniture de trois signaux amplifiés Sa, Sb et Sc, on notera que chaque voie ou branche de l'unité 5 comprend un circuit bouchon 6 formé d'une inductance L1 et d'une capacité C1, un circuit d'adaptation 7 formé d'une inductance L2 et de deux capacités C2 et C3 et un circuit de réjection 8 dont les deux voies ou branches parallèles comprennent chacune une inductance L1 et une capacité C1 correspondant à celles des circuits bouchons 6 des autres voies de l'unité 5.

Les indices a, b et c indiquent l'affectation et l'adaptation des trois voies de l'unité 5 aux trois fréquences Fa, Fb et Fc des signaux primaires sa, sb et sc et des signaux amplifiés Sa, Sb et Sc, ainsi qu'aux trois charges Za, Zb et Zc.

En variante au mode de réalisation décrit ci-dessus, il peut être prévu que chaque circuit L-C série des circuits bouchons 6 et des circuits de réjection 8 soit remplacé par une ligne coaxiale quart d'onde présentant le même réglage fréquentiel.

Le choix des composants et leurs réglages nécessaires à la réalisation pratique du dispositif générateur 1 sont à la portée de l'homme du métier, lorsque ce dernier est en possession des indications des fréquences et des qualités des signaux à fournir (par exemple : Fa = 40 MHz, Fb = 100 MHz et Fc = 400 MHz) ainsi que des valeurs des charges Z, et ne nécessitent, par conséquent, aucun développement supplémentaire.

Selon une caractéristique éventuelle de l'invention, chaque source primaire 2 peut consister en un générateur de porteuse dont le signal de sortie s de fréquence F est modulé, par exemple par un signal en impulsions, au niveau d'un circuit de modulation 9 correspondant, avant sa transmission vers le circuit combineur 3.

Conformément à une application particulièrement avantageuse du dispositif selon l'invention, les différents signaux S délivrés en sortie sont appliqués à des charges Z consistant en des têtes de mesure d'un spectromètre à résonance magnétique nucléaire.

Afin de réduire la transmission de signaux parasitaires et perturbateurs entre l'amplificateur 4 et les différentes sorties de l'unité 5, il peut être avantageusement prévu, selon une variante de réalisation de l'invention que l'unité 5 de sélection et de montage comprenne des moyens 10, 11 d'isolation de son entrée commune E par rapport aux sorties de ses différentes voies.

Les moyens d'isolation consistent préférentiellement en des diodes, préférentiellement du type PIN, une première diode 10 étant montée en série à l'entrée de chaque voie (en aval du point d'entrée commun E et en amont des circuits bouchons respectifs), et une seconde diode 11 étant montée en série à la sortie de chaque voie (dans l'unité 5 et en aval des circuits de réjection 8 respectifs). Avantageusement, la distance entre les paires de diodes 10 et 11 de chaque voie sera fixée à λ/4, pour la fréquence F concernée.

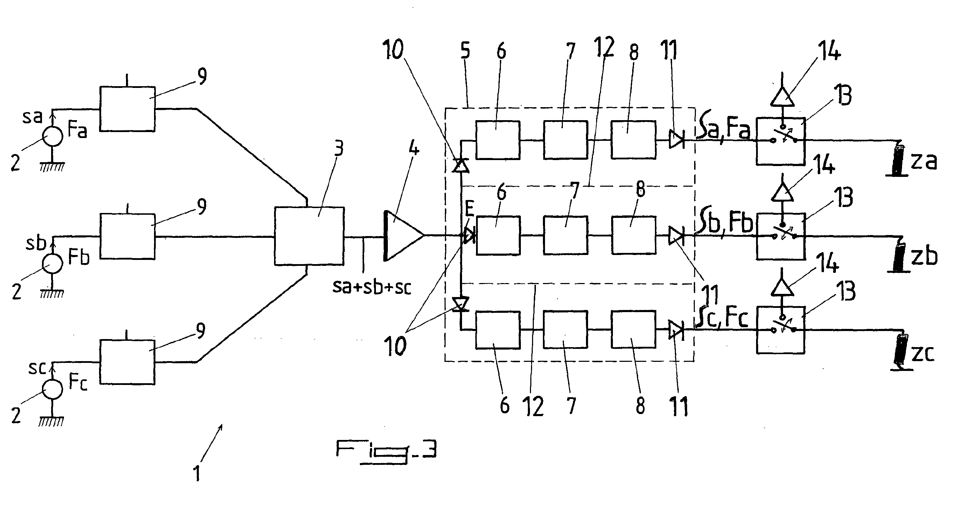

Conformément à une caractéristique complémentaire de l'invention, également représentée à la figure 3 des dessins annexés, l'unité 5 peut en outre comporter des moyens 12 d'isolation électromagnétique supplémentaires entre les voies, par exemple sous la forme de parois de séparation ou de compartimentage, l'unité 5 étant elle-même montée dans une enveloppe ou un boîtier d'isolation électromagnétique (formant au moins partiellement une cage de Faraday), représenté(e) en traits interrompus sur les figures 1 et 3.

La présente invention a également pour objet un dispositif d'analyse, notamment un spectromètre à résonance magnétique nucléaire, caractérisé en ce que ses têtes ou sondes de mesure sont alimentées par un dispositif générateur 1 tel que décrit ci-dessus.

La figure 3 représente schématiquement le système d'émission / réception d'un tel appareil spectrométrique, les charges Za, Zb et Zc correspondant aux têtes ou sondes associées à l'échantillon ou aux échantillons à analyser.

Il se compose essentiellement :
- d'un dispositif générateur tel que décrit ci-dessus fournissant la puissance RF destinée à polariser l'échantillon ou les échantillons à analyser ;
- d'un système 13 de commutation émission / réception par voie, permettant de commuter cette puissance RF vers l'échantillon correspondant en mode émission ou de relier l'échantillon à un récepteur en mode réception ;
- un récepteur 14 à faible facteur de bruit destiné à préamplifier le signal RMN avant traitement dans la chaîne de traitement du signal du spectromètre.

Les moyens d'isolation 10 et 11 permettent d'isoler de manière notable (100 dB) le récepteur de l'émetteur en mode réception. Ceci n'améliore pas significativement les performances d'un spectromètre RMN en configuration "classique" : un amplificateur, un système de commutation et un récepteur, mais permet par contre de nouvelles expériences dans lesquelles plusieurs canaux sont susceptibles d'être utilisés en même temps, comme le permet le dispositif générateur selon l'invention.

Cette technologie ouvre les portes à des configurations nouvelles de spectromètres dans lesquelles un amplificateur pourra piloter plusieurs systèmes de commutation et plusieurs récepteurs. Il sera également possible d'utiliser des amplificateurs 4 parfaitement linéaires non arrêtés ou bloqués ("blanked" en anglais) en mode réception.

L'expérience RMN de base consiste à appliquer à l'échantillon une impulsion RF à durée, puissance et phase maîtrisées, d'éliminer le signal de l'amplificateur 4 (soit lui couper son alimentation HF afin de le rendre moins bruyant) et de commuter le système en mode réception afin d'enregistrer le signal préamplifié par le récepteur. Pendant cette phase critique de réception, tout signal parasite qui pourrait être émis par l'amplificateur 4 serait dans le cas d'une isolation classique facilement du même ordre de grandeur, voire nettement supérieur, au signal RMN de très faible intensité. Le principe de l'isolation renforcée selon l'invention rend impossible la saturation du récepteur par des signaux parasites et permet donc leur élimination par un traitement du signal conventionnel.

Enfin, la présente invention concerne aussi un procédé de production de signaux électriques radiofréquence présentant des fréquences différentes, avec un unique dispositif générateur 1, lesdits signaux étant modulés ou non, caractérisé en ce que ledit procédé consiste à fournir plusieurs signaux s ayant des fréquences F différentes au moyen de plusieurs sources primaires 2, à effectuer, le cas échéant, une modulation de ces différents signaux, à combiner entre eux, sans intermodulation, lesdits signaux s, éventuellement combinés ou mélangés, par l'intermédiaire d'un circuit combineur 3, à amplifier le signal combiné au moyen d'un amplificateur de puissance 4 large bande et éventuellement à gain variable et, enfin, à appliquer le signal combiné amplifié à l'entrée commune E d'une unité 5 de sélection et de routage multivoie à structure parallèle, dont chaque voie comprend un circuit bouchon 6 réglé pour être passant pour l'une des différentes fréquences caractéristiques F des sources primaires 2, un circuit d'adaptation d'impédance 7 et un circuit de réjection 8 pour les fréquences autres que la fréquence passante du circuit bouchon 6 de la voie concernée, et, enfin, à délivrer au niveau de chaque sortie de chacune des différentes voies de ladite unité 5, un signal amplifié S présentant une fréquence F caractéristique d'une des sources primaires 2.

Les différentes caractéristiques et variantes de réalisation des circuits constituant le dispositif générateur 1, telles que décrites ci-dessus, peuvent également s'appliquer dans le cadre du présent procédé.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, notamment des lignes λ/4 réalisées à l'aide de câbles coaxiaux, sans sortir pour autant du domaine de protection de l'invention.

## Revendications

1. Dispositif générateur de signaux électriques radiofréquence, délivrant au moins deux signaux distincts ayant des fréquences différentes, sous la forme de signaux délivrés par des sources primaires différentes et amplifiés avec un gain déterminé, **caractérisé en ce qu'**il comprend, outre lesdites sources primaires (2), d'une part, un circuit combineur (3), combinant entre eux, sans intermodulation, les signaux (s) délivrés par les sources primaires (2), d'autre part, par un amplificateur de puissance large bande monovoie (4) présentant une bande passante adaptée aux différentes fréquences (F) des signaux présents dans le signal combiné issu du circuit combineur (3) et, enfin, par une unité (5) de sélection et de routage multivoie à structure parallèle, dont chaque voie délivre en sortie un signal amplifié (S) à une fréquence (F) caractéristique d'une des sources primaires (2) et comprend un circuit bouchon (6) réglé pour être passant pour l'une des différentes fréquences caractéristiques (F) des différentes sources primaires (2), un circuit d'adaptation d'impédance (7) et un circuit de réjection (8) pour les fréquences autres que la fréquence passante du circuit bouchon (6) de la voie concernée.

2. Dispositif générateur selon la revendication 1, **caractérisé en ce que** l'unité (5) de sélection et de routage comporte au moins trois voies parallèles, préférentiellement entre trois et cinq voies, chaque voie délivrant en sortie un signal amplifié (S) dont la fréquence (F) correspond à celle d'une source primaire (2) spécifique.

3. Dispositif générateur selon l'une quelconque des revendications 1 et 2, **caractérisé en ce que** chaque circuit bouchon (6) consiste en un circuit L-C série, dont la capacité (C1) variable est ajustée pour rendre ledit circuit bouchon (6) résonant à la fréquence de sortie (F) de la voie concernée.

4. Dispositif générateur selon l'une quelconque des revendications 1 à 3, **caractérisé en ce que** chaque circuit d'adaptation consiste en un circuit C-L-C en pi, dont les capacités variables (C1 et C2) sont ajustées pour réaliser une adaptation de la voie concernée à la charge (Z) alimentée par cette dernière.

5. Dispositif générateur selon l'une quelconque des revendications 1 à 4, **caractérisé en ce que** chaque circuit de réjection (8) consiste en plusieurs circuits L-C série montés en parallèle, dont chacun est ajusté pour être résonant à l'une des différentes fréquences de sortie (F) du dispositif (1), autres que celle de la voie concernée de l'unité (5).

6. Dispositif générateur selon les revendications 3 et 5, **caractérisé en ce que** chaque circuit L-C série des circuits bouchons (6) et des circuits de réjection (8) est remplacé par une ligne coaxiale quart d'onde présentant le même réglage fréquentiel.

7. Dispositif générateur selon l'une quelconque des revendications 1 à 6, **caractérisé en ce que** chaque source primaire (2) consiste en un générateur de porteuse dont le signal de sortie (s) de fréquence (F) est modulé, par exemple par un signal en impulsions, au niveau d'un circuit de modulation (9) correspondant, avant sa transmission vers le circuit combineur (3).

8. Dispositif générateur selon l'une quelconque des revendications 1 à 7, **caractérisé en ce que** les différents signaux (S) délivrés en sortie sont appliqués à des charges (Z) consistant en des têtes de mesure d'un spectromètre à résonance magnétique nucléaire.

9. Dispositif générateur selon l'une quelconque des revendications 1 à 8, **caractérisé en ce que** l'unité (5) de sélection et de montage comprend des moyens (10, 11) d'isolation de son entrée commune (E) par rapport aux sorties de ses différentes voies.

10. Dispositif générateur selon la revendication 9, **caractérisé en ce que** les moyens d'isolation consistent préférentiellement en des diodes, une première diode (10) étant montée en série à l'entrée de chaque voie et une seconde diode (11) étant montée en série à la sortie de chaque voie.

11. Dispositif générateur selon l'une quelconque des revendications 9 et 10, **caractérisé en ce que** l'unité (5) peut en outre comporter des moyens (12) d'isolation électromagnétique supplémentaires entre les voies, par exemple sous la forme de parois de séparation ou de compartimentage, l'unité (5) étant elle-même montée dans une enveloppe ou un boîtier d'isolation électromagnétique.

12. Dispositif d'analyse à résonance magnétique nucléaire, notamment spectromètre, **caractérisé en ce que** ses têtes ou sondes de mesure sont alimentées par un dispositif générateur (1) selon l'une quelconque des revendications 1 à 11.

13. Procédé de production de signaux électriques radiofréquence présentant des fréquences différentes, avec un unique dispositif générateur (1), lesdits signaux étant modulés ou non, **caractérisé en ce que** ledit procédé consiste à fournir plusieurs signaux (s) ayant des fréquences (F) différentes au moyen de plusieurs sources primaires (2), à effectuer, le cas échéant, une modulation de ces différents signaux, à combiner entre eux, sans intermodulation, lesdits signaux (s), éventuellement combinés ou mélangés, par l'intermédiaire d'un circuit combineur (3), à amplifier le signal combiné au moyen d'un amplificateur de puissance (4) large bande et éventuellement à gain variable et, enfin, à appliquer le signal combiné amplifié à l'entrée commune (E) d'une unité (5) de sélection et de routage multivoie à structure parallèle, dont chaque voie comprend un circuit bouchon (6) réglé pour être passant pour l'une des différentes fréquences caractéristiques (F) des sources primaires (2), un circuit d'adaptation d'impédance (7) et un circuit de réjection (8) pour les fréquences autres que la fréquence passante du circuit bouchon (6) de la voie concernée, et, enfin, à délivrer au niveau de chaque sortie de chacune des différentes voies de ladite unité (5), un signal amplifié (S) présentant une fréquence (F) caractéristique d'une des sources primaires (2).
